# EUROPÄISCHE PATENTANMELDUNG

(11) **EP 3 422 218 A1**
(43) Veröffentlichungstag der Anmeldung: **02.01.2019**
(21) Anmeldenummer: 17178612.2
(22) Anmeldetag: 29.06.2017
(51) Int. Cl.: G06F 17/50, G05B 19/05, G06F 9/52

(54) **SYNCHRONISATION MEHRERER SIMULATIONEN**

(71) Anmelder: Siemens Aktiengesellschaft, 80333 München (DE)
(72) Erfinder: Laemmle, Beat, 91183 Abenberg (DE)

(57) **Zusammenfassung**

Die Erfindung betrifft ein Verfahren zur Synchronisation mehrerer durch jeweilige Simulationsprogramme ausgeführter Simulationen sowie ein dazugehöriges Computerprogrammprodukt und eine dazugehörige Koordinationseinheit. Dabei werden mehrere durch jeweilige Simulationsprogramme ausgeführte Simulationen synchronisiert, wobei durch eine Koordinationseinheit folgende Schritte ausgeführt werden:
- Ermitteln von jeweiligen Statusmeldungen der Simulationsprogramme zum erfolgten Durchlauf eines jeweiligen Zyklus, wobei je Simulation ein zugehöriger Zyklus durch eine jeweilige Abfolge durch das jeweilige Simulationsprogramm durchzuführender logischer Schritte festgelegt wird,
- Ausgeben jeweils einer Synchronisationsmeldung an ein oder mehrere der Simulationsprogramme, wenn die jeweiligen Statusmeldungen der mehreren Simulationen vorliegen, wobei die Synchronisationsmeldung jeweils einen Start eines nachfolgenden Zyklus des jeweiligen Simulationsprogrammes auslöst.

## Beschreibung

Die Erfindung betrifft ein Verfahren zur Synchronisation mehrerer durch jeweilige Simulationsprogramme ausgeführter Simulationen sowie ein dazugehöriges Computerprogrammprodukt und eine dazugehörige Koordinationseinheit.

In der Industrieautomatisierung, beispielsweise in der industriellen Fertigung, sind Simulationsprozesse von enormer Bedeutung. Prozesse oder Abläufe von Fertigungsschritten oder Transportvorgängen oder Inbetriebnahmen von Maschinen oder Ausführungen von Produktionsschritten werden simuliert, um in einer virtuellen Umgebung feststellen zu können, ob unerwartete Fehler oder Reaktionen oder Komplikationen auftreten. Anhand von Ergebnissen meist einer Vielzahl von Simulation wird eine virtuelle Nachbildung eines Prozesses erreicht. Diese Art der Virtualisierung einzelner Abläufe in einer industriellen Umgebung erleichtert die Planung und ermöglicht ein frühzeitiges Erkennen von Fehleinstellungen, Fehlparametrierungen, Fehlverschaltungen oder Fehlkonstruktionen. Dadurch kann beispielsweise bereits im Vorfeld, z. B. bei einer simulierten und virtuellen Inbetriebnahme, ein ggf. vorhandener Fehler festgestellt werden, der behoben werden kann, bevor Gefahren durch eine nicht funktionierende Anlage oder Kosten durch Zerstörung von Anlagenteilen entstehen.

Die Möglichkeiten der Simulationen werden dabei immer weitreichender. Es sind immer komplexere Berechnungen zur Simulation möglich und immer exaktere Vorhersagen beim Zusammenspiel beispielsweise einzelner Anlagenteile oder Komponenten einer Anlage. Dabei werden einzelne Teilaspekte oder einzelne Automatisierungsteilschritte simuliert, welche in der Realität Abhängigkeiten aufweisen. Beispielsweise laufen in der Realität Prozesse gleichzeitig zueinander ab oder weisen zu einem Zeitpunkt im Prozess eine Abhängigkeit voneinander auf. Beispielsweise werden an einer Stelle im Produktionsablauf Eingabedaten verarbeitet, welche von einem anderen Prozess generiert werden.

Zwischen verschiedenen real ablaufenden Prozessen ist somit eine Möglichkeit der Synchronisation gefordert. Ebenso soll eine Simulation, welche mehrere Teilsimulationen umfasst, koordiniert werden können. Insbesondere wird für komplexe Simulationen eine gesamte Simulation in viele parallele Simulationen zerlegt, welche parallel zueinander abgearbeitet werden sollen. Da die verschiedenen Teilsimulationen die End- oder Gesamtsimulation beeinflussen, wird eine Synchronisation dieser Teilsimulationen erforderlich.

Die Synchronisation von Simulationen, die in Software implementiert sind, aber in unterschiedlichen Prozessen oder auf unterschiedlichen Rechnern ablaufen, ist für ein gleichmäßiges Voranschreiten der Simulationen und eine korrekte Simulation im Ganzen notwendig. Simulationen werden auf Simulationstools, also in Software, in der Regel entweder zu schnell oder zu langsam ausgeführt. Für die Betrachtung einer einzelnen Simulation ist dies in der Regel unkritisch, wenn ein Abbildungsfaktor zwischen reeller Zeit und virtueller Zeit ermittelbar ist und somit berücksichtigt werden kann. Für mehrere abhängige Simulationen ist dies jedoch nicht unkritisch. Dazu kommt, dass in der Regel Simulationen nicht gleichmäßig schnell oder langsam ausgeführt werden. Je nach Komplexität, welche sich innerhalb eines simulierten Prozesses durch logische Abzweigungen erweitern oder reduzieren kann, verändert sich die Schnelligkeit einer Simulation. Ferner kann eine verfügbare Rechenkapazität die Simulationszeiten beeinflussen, beispielsweise im Falle mehrerer auf einem Rechner ablaufender Simulationen.

Ein Lösungsweg, welcher darauf abzielt, eine bestimmte reale Zeit von einem Simulationsprogramm simulieren zu lassen, unabhängig von der dafür benötigten Zeit, scheitert oftmals daran, dass viele Simulationen diese Funktionalität nicht aufweisen. Dies liegt beispielsweise daran, dass während eines Ablaufs einer Simulation durch das System nicht geprüft werden kann, wie viel Zeit abgelaufen ist. Beispielsweise kann eine PLC erst am Ende des Zyklus, also im Nachhinein, prüfen, ob eine vorgegebene Zeit überschritten wurde oder nicht.

Aufgrund der Unregelmäßigkeit bei der benötigten Simulationszeit für eine vorgegebene simulierte Zeit benötigt auch das Ausführen von Programmcodes je nach simuliertem Programm unterschiedlich lange.

Es sind Lösungen bekannt, welche eine virtuelle Zeit nutzen. Zu synchronisierende Simulationen werden so konfiguriert, dass sie sich zur Laufzeit auf einen Faktor zur Ermittlung für die virtuelle Zeit einigen. Dabei werden Simulationen teilweise so gebremst, dass alle Simulationen rechtzeitig fertig werden. Die Simulationen laufen dabei unkoordiniert. Schnell ablaufende Simulationen warten auf die langsamste Simulation und die dadurch auf die meisten Simulationen angewandte gebremste Geschwindigkeit verlangsamt somit die einzelnen Simulationsprozesse und belegt ggf. Rechenkapazität. Außerdem rechnen Simulationen ggf. mit falschen Daten, falls Abhängigkeiten zwischen den einzelnen Simulationen bestehen.

In einer anderen Variante wird den Simulationen nacheinander eine Zeitscheibe zugeteilt und dann abgewartet, wie viel Zeit die gerade laufende Simulation wirklich simuliert hat. Die bereits abgelaufene Zeit kann dann in Zeitscheiben der folgenden Simulationen verrechnet werden. Nachteilig ist eine stark verlängerte Laufzeit, weil zu jedem Zeitpunkt nur eine Simulation arbeitet.

Vor diesem Hintergrund besteht die Aufgabe der vorliegenden Erfindung darin, eine verbesserte Synchronisation mehrerer Simulationen und gleichzeitig effiziente Abarbeitung der Simulationen bereitzustellen. Diese Aufgabe wird durch die vorliegenden unabhängigen Ansprüche gelöst. Vorteilhafte Ausgestaltungen sind in den abhängigen Ansprüchen angegeben.

Die Erfindung betrifft ein Verfahren zur Synchronisation mehrerer durch jeweilige Simulationsprogramme ausgeführter Simulationen, wobei durch eine Koordinationseinheit folgende Schritte ausgeführt werden:
- Ermitteln von jeweiligen Statusmeldungen der Simulationsprogramme zum erfolgten Durchlauf eines jeweiligen Zyklus, wobei je Simulation ein zugehöriger Zyklus durch eine jeweilige Abfolge durch das jeweilige Simulationsprogramm durchzuführender logischer Schritte festgelegt wird,
- Ausgeben jeweils einer Synchronisationsmeldung an einer oder mehrerer der Simulationsprogramme, wenn die jeweiligen Statusmeldungen der mehreren Simulationen vorliegen, wobei die Synchronisationsmeldung jeweils einen Start eines nachfolgenden Zyklus des jeweiligen Simulationsprogrammes auslöst.

Es erfolgt eine Synchronisation anhand von Zyklen. Ein Zyklus wird durch eine Abfolge logischer Schritte festgelegt, welche durch ein Simulationsprogramm durchzuführen sind. Es handelt sich demnach um einen Abschnitt eines Programmes, welcher insbesondere einen logisch abgeschlossenen Programmablauf darstellt. Beispielsweise wird in einem Zyklus gerade ein Simulationsabschnitt durchgerechnet. Es handelt sich dabei nicht um eine durch eine real oder virtuell ablaufende Zeit vorgegebene Zeitspanne. Weder wird durch einen Zyklus eine Zeit vorgegeben, welche real für eine Simulation benötigt wird, noch wird vorgegeben, welche Zeitspanne durch ein Simulationsprogramm zu simulieren ist.

Somit wird eine Zyklussynchronisierung erreicht. Statusmeldungen der Simulationsprogramme geben an, wenn ein Zyklus beendet wurde. Ein erfolgter Durchlauf eines Zyklus wird somit an die Koordinationseinheit gemeldet. Die Koordinationseinheit empfängt und ermittelt jeweilige Statusmeldungen und hat so Kenntnis darüber, welche der mehreren Simulationen einen Zyklus zu Ende gerechnet haben. Durch die Koordinationseinheit erfolgt ein Ausgeben einer Synchronisationsmeldung, wenn jeweils die Statusmeldung der zu synchronisierenden Simulation vorliegt. Synchronisationsmeldung bedeutet dabei, dass den einzelnen Simulationen eine Nachricht übermittelt wird, welche jeweils ein Starten eines nachfolgenden Zyklus im jeweiligen Simulationsprogramm anstößt.

Somit erfahren alle Simulationen davon, dass auch alle anderen Simulationen ihren Zyklus abgearbeitet haben. Auch die langsamste, d.h. in der realen Zeit am längsten brauchende Simulation, ist fertig und bereit für den nächsten Zyklus, wenn die Synchronisationsmeldung verschickt wird. Somit wird optimal mit der höchstmöglichen Wiederholrate je Simulationsprogramm der Zyklus gerechnet und gleichzeitig dabei die Synchronisation der Simulationen sichergestellt.

Ein Zyklus, in welchem beispielsweise eine Schleife im programmtechnischen Sinne abgearbeitet wird, oder eine Folge abgearbeitet wird, kann mehr oder weniger komplex ausfallen. Ein zu simulierender Schritt in einem Prozessablauf kann beispielsweise durch variable Eingaben oder Abhängigkeiten von Umgebungsbedingungen unterschiedlich komplex ausfallen. Beispielsweise wird je nach einer Nutzerangabe oder je nach einem äußeren Einfluss auf einen Prozess durch einen anderen Prozess oder durch Umgebungsbedingungen ein komplizierterer oder weniger komplizierter Simulationsalgorithmus aufgerufen. Beispielsweise benötigt dieser kompliziertere Algorithmus eine längere Zeit zum Durchrechnen des Zyklus als bei anderen die Simulation beeinflussenden Eingangsgrößen, beispielsweise anderen Nutzerangaben oder Umgebungsbedingungen.

Simulationen, die ihren Zyklus schneller fertig gerechnet haben als andere, werden durch das Warten auf die Synchronisationsmeldung gebremst, bevor der nächste Simulationszyklus startet. Somit erfolgt ein Bremsen schnellerer Simulationen zur Synchronisation mit langsameren Simulationen auf vorteilhafte Weise ohne dabei eine virtuelle Zeit einführen zu müssen oder gar eine virtuelle Geschwindigkeit der Zeit. Schnelle Simulationen können auf vorteilhafte Weise ihren Zyklus schnellstmöglich durchrechnen und stehen während der Wartezeit für andere Vorgänge zur Verfügung. Dies optimiert die Auslastung der Rechenkapazität. Auf vorteilhafte Weise entfällt ein manuelles Einstellen der Geschwindigkeit der Zeit bei mehreren Simulationen, welche über einen gemeinsamen virtuellen Zeitbegriff synchronisiert werden sollen. Jede Simulation wäre über einen Faktor separat anzupassen und dies ggf. auch während der Laufzeit, wenn sich die Geschwindigkeit der virtuellen Zeit ändert. Weder ist überhaupt ein Zeitbegriff nötig, noch müssen sich die Simulationen auf einen gemeinsamen Zeitbegriff einigen. Insbesondere für Simulationen, welche keinen Zeitbegriff haben oder kennen und lediglich in Zyklen arbeiten und insbesondere einen Zyklus immer fertig rechnen müssen, stellt die Lösung eine vorteilhafte Möglichkeit der Synchronisation mit anderen Simulationen anhand des Zyklusbegriffes dar.

Ein Zyklus wird beispielsweise dadurch festgelegt, dass mehrere parallele Simulationen einen Programmablauf abgearbeitet haben, nach dem ein Datenaustausch vorgesehen ist. Das Ende eines Zyklus kann beispielsweise durch eine Stelle im Programmablauf definiert werden, an dem der Datenaustausch im realen Prozess stattfinden soll.

Die jeweilige Definition eines Zyklus von unterschiedlichen zu synchronisierenden Simulationen kann gleich oder verschieden voneinander sein. Beispielsweise entsprechen sich die Definitionen von jeweiligen Zyklen verschiedener Simulationen. Es ist aber genauso möglich, Übersetzungsverhältnisse einzubauen. Wenn beispielsweise eine Simulation in einem ihrer Zyklen z.B. aggregierte Daten einer anderen Simulation aus drei Zyklen verarbeitet, so ist das Verhältnis 3:1.

Die vorgestellte Synchronisation anhand der Zyklen ist vorteilhafterweise unabhängig davon, ob eine Geschwindigkeit der simulierten Zeit gleichmäßig ist oder gleichmäßig bleibt. Welche Simulation der mehreren Simulationen die längste Zeit benötigt, um ihren Zyklus zu berechnen, spielt für die Synchronisationsmeldung keine Rolle. Es wird immer auf die langsamste Simulation gewartet und erst dann die Synchronisationsmeldung ausgegeben.

Die Koordinationseinheit wirkt als Master für ein Starten eines Zyklus. An dieser Stelle, welche zentral oder dezentral vorgesehen sein kann, wird für alle zu synchronisierenden Simulationen das Voranschreiten der jeweiligen Simulation als Master vorgegeben.

Gemäß einer Ausgestaltung sind die jeweiligen Zyklen je nach Ablauf des jeweiligen Simulationsprogrammes unterschiedlich ausgestaltet. Beispielsweise bleibt die Definition eines Zyklus gleich, der Zyklus oder die Abarbeitung des Zyklus fällt aber innerhalb dieser Definition unterschiedlich aus, beispielsweise je nach Einflüssen aus anderen Simulationen. Insbesondere dauert ein Zyklus über die Zeit betrachtet unterschiedlich lange.

Gemäß einem Ausführungsbeispiel ist das Ausgeben der jeweiligen Synchronisationsmeldung erst möglich, wenn die Statusmeldungen aller zu synchronisierenden Simulationsprogramme ermittelt wurden. Es wird somit sichergestellt, dass kein Simulationsprogramm einen nachfolgenden Zyklus startet, solange nicht alle anderen den aktuellen Zyklus abgeschlossen haben.

Gemäß einer Ausgestaltung tauscht die Koordinationseinheit mit den jeweiligen Simulationsprogrammen Daten über einen bidirektionalen Kommunikationskanal aus. Beispielsweise handelt es sich um einen Pipe-Mechanismus, d.h. einen bidirektionalen, seriellen Kommunikationskanal zwischen zwei Endpunkten. Dieser Mechanismus wird vom Betriebssystem einer Recheneinheit, auf der die Simulationsprogramme laufen, bereitgestellt. Auf vorteilhafte Weise kann das Betriebssystem freiwerdende Ressourcen für wartende Simulationsprogramme einem anderen Prozess zuteilen.

Gemäß einer Ausgestaltung werden die jeweiligen Statusmeldungen von den jeweiligen Simulationsprogrammen über den bidirektionalen Kommunikationskanal durch die Koordinationseinheit empfangen. Auf vorteilhafte Weise kann ein Pipe-Mechanismus eines Betriebssystems für die Übertragung der Statusmeldungen genutzt werden.

Gemäß einer Ausgestaltung werden die jeweiligen Synchronisationsmeldungen von der Koordinationseinheit über den bidirektionalen Kommunikationskanal an die jeweiligen Simulationsprogramme gesendet. Vorteilhafterweise wird auch für die Übertragung der Synchronisationsmeldungen die Pipe eines Betriebssystems genutzt. Alternativ zu einem Pipe-Mechanismus sind auch Übertragungen der Synchronisationsmeldungen und der Statusmeldungen über ein Netzwerk denkbar. Insbesondere in Fällen, in welchen mehrere Simulationen auf einem Rechner und zusätzlich weitere Simulationen auf einem anderen Rechner laufen und eine Koordinationseinheit auf einem der beiden Rechner als Koordinationseinheit und Master für alle Simulationen vorgesehen ist, können Netzwerkverbindungen auf vorteilhafte Weise genutzt werden.

Gemäß einer Ausgestaltung ermittelt die Koordinationseinheit eine jeweilige Zykluszählerinformation je Simulationsprogramm. Beispielsweise meldet sich jede Simulation bei der Koordinationseinheit mit ihrem aktuellen Zykluszähler. Dies geschieht beispielsweise beim Anfahren oder Starten einer Simulation oder beim Integrieren einer zusätzlichen Simulation zu einer Menge bestehender Simulationen. Es können sich verschiedene zu synchronisierende Simulationen zu voneinander abweichenden Zeitpunkten bei der Koordinationseinheit melden und ihre jeweilige Simulation starten. Es muss damit insbesondere nicht von vornherein klar sein oder festgelegt sein, welche Simulationen letztendlich miteinander synchronisiert werden sollen. Auch große zeitliche Abstände des Startzeitpunktes verschiedener Simulationen können durch die Kenntnis des Zykluszählerstandes durch die Koordinationseinheit berücksichtigt werden. Ein Stoppen der weiteren zu synchronisierenden Simulationen, bis ein einheitlicher Zykluszählerstand bei allen Synchronisationen vorliegt, ist ebenso denkbar wie ein Berücksichtigen der Zykluszählerdifferenzen zum Zeitpunkt einer simulierten Synchronisation.

Gemäß einer Ausgestaltung werden gemeinsam mit der Synchronisationsmeldung oder vor einer Verarbeitung der Synchronisationsmeldung den Simulationsprogrammen aktualisierte Eingabedaten oder eine Benachrichtigung über eine Aktualisierung von Eingabedaten von der Koordinationseinheit oder von den Simulationsprogrammen gegenseitig bereitgestellt. Vor dem Senden der Synchronisationsmeldung kann die Koordinationseinheit beispielsweise neue Eingabedaten an die jeweiligen Simulationsprogramme bereitstellen. Diese Eingabedaten können durch aktuelle simulierte Ausgabedaten anderer Simulationen gebildet oder beeinflusst sein. Diese Eingabedaten können auch unter den Simulationsprogrammen gegenseitig ausgetauscht werden. Für letzteren Fall sollte sichergestellt sein, dass ein Verarbeiten oder Analysieren der Eingangsdaten jedoch erst erfolgt, wenn die Synchronisationsmeldung ausgegeben wurde. Neben der Übermittlung der aktualisierten Eingabedaten selbst ist auch eine Übermittlung einer Benachrichtigung über diese Aktualisierung der Eingabedaten denkbar. Somit kann die Benachrichtigung erfolgen, dass eine Simulation die korrekten Eingabedaten vorliegen hat. Auf vorteilhafte Weise kann der Datenaustausch in der Pause nach Beendigung aller Zyklen und vor Start des nächsten Zyklus erfolgen.

Auch der reale Datenaustausch kann als eigene Simulation abgebildet werden. An dieser Stelle kann für die Simulation des Datenaustausches zugleich die Zykluszählerinformation berücksichtigt werden.

Gemäß einer Ausgestaltung wird je Simulation ein Zyklus zugewiesen, insbesondere durch das jeweilige Simulationsprogramm oder die Koordinationseinheit. Beispielsweise wird in jeder einzelnen Simulation eingestellt, wann diese einzelne Simulation ihren Zyklus als erfüllt sieht. Beispielsweise wird durch ein Simulationsprogramm für die Simulation einer speicherprogrammierbaren Steuerung (PLC) ein eingestellter Takt des mit der PLC verbundenen Busses gewählt. Für die Simulation einer Mechanik wird der Zyklus beispielsweise in den Einstellungen der Simulation eingestellt. Für Simulationen eines Antriebes oder Prozesses stellt ein Anwender einen Zyklus für die Berechnung ein. Simulationen können somit mit eigenen Mitteln den Zyklus durch den Anwender definieren. Eine einzelne Simulation muss vorteilhafterweise nicht zwangsläufig wissen, mit welchen anderen Simulationen sie synchronisiert wird oder werden wird.

Die Erfindung betrifft ferner ein Computerprogrammprodukt mit einem Computerprogramm, das Mittel zur Durchführung des oben beschriebenen Verfahrens aufweist, wenn das Computerprogramm auf einer programmgesteuerten Einrichtung zur Ausführung gebracht wird.

Die Erfindung betrifft ferner eine Koordinationseinheit auf einem Rechner, wobei die Koordinationseinheit zur Ausführung der Verfahrensschritte nach dem oben beschriebenen Verfahren ausgestaltet ist und wobei die Koordinationseinheit mit den Simulationsprogrammen kommunikativ verbunden ist.

Gemäß einer Ausgestaltung ist die Koordinationseinheit auf dem Rechner gemeinsam mit einer oder mehrerer der Simulationsprogramme ausgeführt.

Gemäß einer Ausgestaltung werden die mehreren Simulationsprogramme auf einem oder mehreren separaten Rechnern ausgeführt.

Die Erfindung betrifft ferner ein Computerprogrammprodukt mit einem Computerprogramm, das Mittel zur Durchführung des oben beschriebenen Verfahrens aufweist, wenn das Computerprogramm auf einer programmgesteuerten Einrichtung zur Ausführung gebracht wird.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen. Als programmgesteuerte Einrichtung kommt insbesondere eine Steuereinrichtung in Frage, wie zum Beispiel ein Prozessor oder Mikroprozessor. Unter einem Prozessor ist eine elektronische Schaltung zum computerbasierten Datenverarbeitung zu verstehen, beispielsweise eine CPU. Es kann sich um die CPU eines Computers handeln oder um einen Mikroprozessor eines Mikrochips.

Die Koordinationseinheit kann hardwaretechnisch und/oder auch softwaretechnisch implementiert sein. Bei einer hardwaretechnischen Implementierung kann die Koordinationseinheit als Vorrichtung oder als Teil einer Vorrichtung, zum Beispiel als Computer oder als Prozessor oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die Erfindung wird nachfolgend anhand von Ausführungsbeispielen mit Hilfe der Figuren näher erläutert. Es zeigen:
- Figur 1: eine schematische Darstellung der Verfahrensschritte gemäß einem Ausführungsbeispiel der Erfindung;
- Figur 2: eine schematische Darstellung ablaufender Simulationszyklen über der Zeit zur Veranschaulichung einer Zyklussynchronizität.

Zur Veranschaulichung der vorliegenden Erfindung wird beispielsweise ein Prozess zum Abbremsen eines Antriebes für eine Produktionsmaschine zugrunde gelegt, welcher simuliert werden soll. Dabei soll der Antrieb für den normalen Betrieb mit einer vorgebbaren und anpassungsbaren Drehzahl arbeiten und nach Einleiten eines Stoppvorganges die Drehzahl entsprechend eines gewählten Stopp-Modus reduziert werden. Bei der Simulation eines solchen Prozesses sind eine Vielzahl von dabei ablaufenden Vorgängen zu simulieren und aufeinander abzustimmen. Die Simulation des mechanischen Abbremsvorgangs sowie einer möglicherweise stattfindenden Nutzereingabe sowie durch eine Bewegungssteuerung ausgelöste Eingriffe in den Abbremsvorgang gilt es zu berücksichtigen. Beispielsweise ergeben sich für ein solches Szenario drei Simulationen, eine für die Steuerung, eine für den Antrieb und eine für die Mechanik. Sich gegenseitig beeinflussende Simulationen sind derart durchzuführen, dass eine Synchronisation zwischen ihnen stattfindet. So können die Teilsimulationen auf aktuelle Daten anderer Teilsimulationen zugreifen.

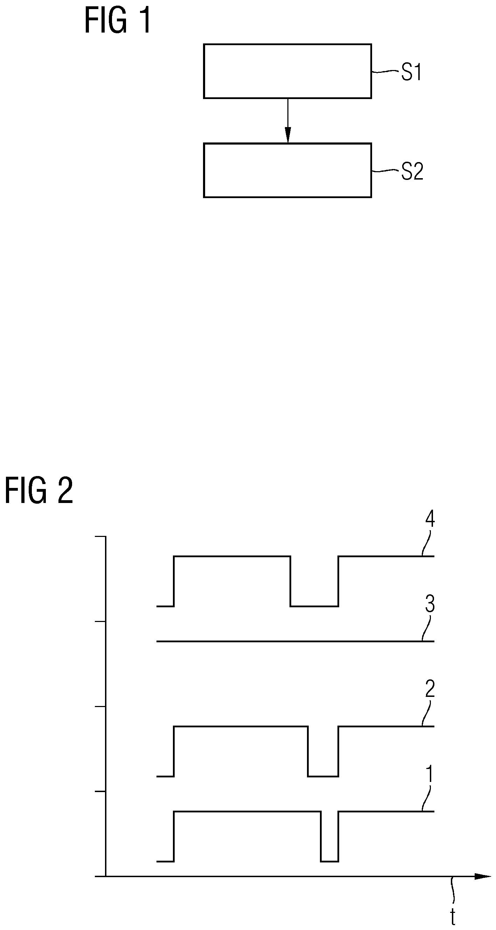

Figur 1 zeigt die wesentlichen ablaufenden Verfahrensschritte, das Ermitteln S1 von Statusmeldungen der Simulationsprogramme und das Ausgeben S2 einer Synchronisationsmeldung an die Simulationsprogramme. Ausgeführt werden diese Schritte von einer Koordinationseinheit oder Koordinationsstelle, welche mit den Simulationsprogrammen kommunikativ verbunden ist. Diese Koordinationseinheit fungiert als Master im Hinblick auf das Starten neuer Simulationszyklen. Ein Simulationszyklus wird beispielsweise durch die Abarbeitung eines Programmcodes gebildet, welcher eine bestimmte Funktion simuliert. Wie viel Zeilen Programmcode dafür auszuführen sind, kann sich beliebig oft ändern. Beispielsweise wird das Auslösen eines Not-Stops simuliert, wobei je nach angenommener Bewegung einer Hand in der Nähe einer Fertigungsmaschine verschiedene Reaktionen ausgelöst werden.

Beispielsweise sind für die Ermittlung des Simulationsergebnisses der Drehzahlvorgabe neben den relativ konstant bleibenden und vorhersehbaren Einflüsse durch die Simulation der Bewegungssteuerung ferner die unregelmäßigen und schwankenden Eingabedaten durch die Simulation eines Nutzereingabeprozesses zu berücksichtigen. Daher soll die Synchronisation der verschiedenen Prozesse gerade nicht anhand einer tatsächlich für eine Simulation benötigten Rechenzeit und auch nicht anhand einer vorgegebenen zu simulierenden Zeit festgelegt werden. Stattdessen wird die Abarbeitung von Zyklen und das Beenden von Zyklen als Trigger für eine Synchronisation genutzt.

Das Ermitteln S1 von Statusmeldungen der zu synchronisierenden Simulationsprogramme erfolgt im vorliegenden Beispiel durch die Auswertung empfangener Statusmeldungen durch die Koordinationseinheit. Die verschiedenen Simulationen senden ihre Statusmeldung dann an die Koordinationseinheit, wenn ihr Zyklus durchlaufen wurde. Die Statusmeldung beinhaltet somit beispielshalber die Aussage "Zyklus Simulation 01 fertig gerechnet".

Die Koordinationseinheit veranlasst den Schritt des Ausgebens S2 der Synchronisationsmeldungen an alle zu synchronisierenden Simulationsprogramme dann, wenn die jeweiligen Statusmeldungen aller Simulationen vorliegen. Damit wurde auch die langsamste laufende Simulation durch die Koordinationseinheit berücksichtigt und das Starten des nächsten Zyklus wird in den verschiedenen Simulationen synchron aufeinander abgestimmt durchgeführt.

Zur Veranschaulichung des Synchronisationseffektes, der durch die vorliegende Erfindung erzielt wird, zeigt Figur 2 beispielshalber vier Simulationen in einem Diagramm übereinander und über die Zeit aufgetragen. Ein Verlauf der jeweiligen Simulationskurve auf jeweils niedrigem Wert zeigt dabei die Zeiträume an, in welchen ein Zyklus fertig gerechnet ist und der nächste noch nicht begonnen hat, die Zeiträume, in welchen eine jeweilige Simulationskurve 1,2,3,4 auf höherem Niveau verläuft, zeigt die Phasen der laufenden Simulation des Zyklus. Man erkennt zu einem Zeitpunkt t den gemeinsamen, synchronen Start der drei Simulationen 1,2 und 4. Diese drei Simulationen 1,2,4 starten einen neuen Zyklus. Ebenso startet die Simulation 3 ihren Zyklus. Diese ist als langsamste Simulation durchgängig am Rechnen von Zyklen. Die Pause zwischen einem Zyklus und dem nachfolgenden Zyklus ist in dieser Darstellung nicht dargestellt. Ebenso sind Varianten denkbar, in welchen alle vier Simulationen 1,2,3,4 eine kurze gemeinsame Pause aufweisen und gemeinsam einen nachfolgenden Zyklus starten. Die gezeigte Variante ist dabei die effizienteste in Hinblick auf die für die Simulationen benötigte Rechenzeit.

Auf vorteilhafte Weise greifen Simulationen auf aktuelle Daten anderer Simulationen zu und gleichzeitig rechnen alle Simulationen parallel mit der größtmöglichen Geschwindigkeit. Zeiten, in welchen Rechenkapazität für die Simulation in einem Simulationsprogramm nicht benötigt wird, werden von anderen Prozessen genutzt. Ein Rechner mit mehreren Kernen wird dabei optimal ausgenutzt. Durch die Nutzung von Mitteln des Betriebssystems zum Anhalten von schnellen Simulationen, beispielsweise der weiter oben beschriebenen Pipe, stehen dem Betriebssystem Informationen zur Verfügung, um die langsameren Simulationen mit mehr Rechenzeit zu versorgen. Damit muss nicht auf ein Worst-Case-Szenario bei der Konfiguration abgestellt werden, sondern es kann flexibel auf benötigte Rechenkapazitäten je Simulation eingegangen werden.

Daten aus einer Simulation beispielsweise einer sog. PLC oder speicherprogrammierbaren Steuerung werden zyklussynchron in eine andere Simulation, beispielsweise die eines gesteuerten Prozesses, beispielsweise eines Fertigungsprozesses, integriert.

Auch in der Realität stattfindende Datenübertragungen, beispielsweise über einen Hardware-Bus zwischen Steuerung und Antrieb, können simuliert und diese Simulation mit anderen Simulationen synchronisiert werden. Steuerung und Antrieb kommunizieren beispielsweise über diverse Software- und Hardwareschichten. Sowohl die Hardware- als auch Teile der Softwareschichten werden vorteilhafterweise in einer Simulation aus Geschwindigkeitsgründen weggelassen und stattdessen andere Kommunikationsmittel eingesetzt.

Diese anderen Kommunikationsmittel bilden die Simulationsgrundlage für den Datenaustausch. Dabei kann die Simulation des Datenaustausches auch eine Umsetzung von Datenformaten, Normierungen usw. vornehmen und simuliert dann etwas mehr als nur den Datenaustausch.

Eine Manipulation des Zeitbegriffes und überhaupt das Vorhandensein und Kennen eines Zeitbegriffes in unterschiedlichen Simulationen entfällt auf vorteilhafte Weise. Ein vorteilhafter Effekt davon ist auch, dass beispielsweise für eine Simulation einer speicherprogrammierbaren Steuerung eine Zeit, die diese Steuerung für ihren Zyklus braucht, mit 0 angenommen werden kann. Würde die Geschwindigkeit der Zeit für die Synchronisation verwendet werden, so würde dieser Ansatz scheitern, weil die Geschwindigkeit unendlich schnell wäre. Auch würde damit die Synchronisation anhand eines Zeitbegriffes scheitern. Sollte in speziellen Anwendungsfällen ein Zeitbegriff von einer Simulation benötigt werden, beispielsweise eine Zeitinformation einer Anwendung als Ausgabe bereitgestellt werden sollen, so kann eine Simulation anhand des eigenen Zyklus auf die Zeit zurückrechnen.

Obwohl die Erfindung im Detail durch die Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Synchronisation mehrerer durch jeweilige Simulationsprogramme ausgeführter Simulationen, wobei durch eine Koordinationseinheit folgende Schritte ausgeführt werden:
- Ermitteln (S1) von jeweiligen Statusmeldungen der Simulationsprogramme zum erfolgten Durchlauf eines jeweiligen Zyklus, wobei je Simulation ein zugehöriger Zyklus durch eine jeweilige Abfolge durch das jeweilige Simulationsprogramm durchzuführender logischer Schritte festgelegt wird,
- Ausgeben (S2) jeweils einer Synchronisationsmeldung an ein oder mehrere der Simulationsprogramme, wenn die jeweiligen Statusmeldungen der mehreren Simulationen vorliegen, wobei die Synchronisationsmeldung jeweils einen Start eines nachfolgenden Zyklus des jeweiligen Simulationsprogrammes auslöst.

2. Verfahren nach Anspruch 1, wobei die jeweiligen Zyklen je nach Ablauf des jeweiligen Simulationsprogrammes unterschiedlich ausgestaltet sind.

3. Verfahren nach Anspruch 1 oder 2, wobei das Ausgeben der jeweiligen Synchronisationsmeldung erst möglich ist, wenn die Statusmeldungen aller zu synchronisierenden Simulationsprogramme ermittelt wurden.

4. Verfahren nach einem der vorstehenden Ansprüche, wobei die Koordinationseinheit mit den jeweiligen Simulationsprogrammen über einen bidirektionalen Kommunikationskanal Daten austauscht.

5. Verfahren nach Anspruch 4, wobei die jeweiligen Statusmeldungen von den jeweiligen Simulationsprogrammen über den bidirektionalen Kommunikationskanal durch die Koordinationseinheit empfangen werden.

6. Verfahren nach Anspruch 4 oder 5, wobei die jeweiligen Synchronisationsmeldungen von der Koordinationseinheit über den bidirektionalen Kommunikationskanal an die jeweiligen Simulationsprogramme gesendet werden.

7. Verfahren nach einem der vorstehenden Ansprüche, wobei die Koordinationseinheit eine jeweilige Zykluszählerinformation je Simulationsprogramm ermittelt.

8. Verfahren nach einem der vorstehenden Ansprüche, wobei gemeinsam mit der Synchronisationsmeldung oder vor einer Verarbeitung der Synchronisationsmeldung den Simulationsprogrammen aktualisierte Eingabedaten oder eine Benachrichtigung über eine Aktualisierung von Eingabedaten von der Koordinationseinheit oder von den Simulationsprogrammen gegenseitig bereitgestellt werden.

9. Verfahren nach einem der vorstehenden Ansprüche, wobei je Simulation ein Zyklus zugewiesen wird, insbesondere durch das jeweilige Simulationsprogramm oder die Koordinationseinheit.

10. Computerprogrammprodukt mit einem Computerprogramm, das Mittel zur Durchführung des Verfahrens nach einem der Ansprüche 1 bis 9 aufweist, wenn das Computerprogramm auf einer programmgesteuerten Einrichtung zur Ausführung gebracht wird.

11. Koordinationseinheit auf einem Rechner, wobei die Koordinationseinheit zur Ausführung der Verfahrensschritte nach einem der Ansprüche 1 bis 9 ausgestaltet ist und wobei die Koordinationseinheit mit den Simulationsprogrammen kommunikativ verbunden ist.

12. Koordinationseinheit nach Anspruch 11, wobei die Koordinationseinheit auf dem Rechner gemeinsam mit einer oder mehrerer der Simulationsprogramme ausgeführt wird.

13. Koordinationseinheit nach Anspruch 11, wobei die mehreren Simulationsprogramme auf einem oder mehreren separaten Rechnern ausgeführt werden.
